(19) Europäisches Patentamt
European Patent Office
Office européen des brevets

(11) Veröffentlichungsnummer : **0 055 814**
**B2**

# (12) NEUE EUROPÄISCHE PATENTSCHRIFT

(45) Veröffentlichungstag der neuen Patentschrift : **17.05.89**

(21) Anmeldenummer : **81109002.6**

(22) Anmeldetag : **27.10.81**

(51) Int. Cl.$^4$ : **G 03 C 1/56**, C 08 G 8/32, C 08 L 61/04, G 03 F 7/08, G 03 F 7/26

## (54) Lichtempfindliches Gemisch, das einen Naphthochinondiazidsulfonsäureester enthält, und Verfahren zur Herstellung des Naphthochinondiazidsulfonsäureesters.

(30) Priorität : **03.01.81 DE 3100077**

(43) Veröffentlichungstag der Anmeldung : **14.07.82 Patentblatt 82/28**

(45) Bekanntmachung des Hinweises auf die Patenterteilung : **05.03.86 Patentblatt 86/10**

(45) Bekanntmachung des Hinweises auf die Entscheidung über den Einspruch : **17.05.89 Patentblatt 89/20**

(84) Benannte Vertragsstaaten :
**AT BE CH DE FR GB IT LI NL SE**

(56) Entgegenhaltungen :
**DE-A- 2 044 868**
**DE-A- 2 146 166**
**DE-A- 2 626 473**
**DE-A- 2 641 099**
**DE-A- 2 657 922**
**DE-A- 2 843 069**
**DE-A- 2 847 878**
**DE-A- 3 009 873**

**Die Akte enthält technische Angaben, die nach dem Eingang der Anmeldung eingereicht wurden und die nicht in dieser Patentschrift enthalten sind.**

(73) Patentinhaber : **HOECHST AKTIENGESELLSCHAFT**
**Postfach 80 03 20**
**D-6230 Frankfurt am Main 80 (DE)**

(72) Erfinder : **Erdmann, Fritz, Dr.**
**Hermann-Hesse-Strasse 39**
**D-6500 Mainz 31 (DE)**
Erfinder : **Simon, Ulrich, Dr.**
**Fontanestrasse 41**
**D-6500 Mainz 31 (DE)**

**EP 0 055 814 B2**

## Beschreibung

Die Erfindung betrifft ein lichtempfindliches Gemisch, das einen Naphthochinondiazidsulfonsäureest er und ein wasserunlösliches, in wäßrig-alkalischen Lösungen lösliches Bindemittel enthält und vorzugsweise zur Herstellung von Druckplatten und Photoresists bestimmt ist.

Gemische der genannten Gattung und daraus hergestellte lichtempfindliche Kopiermaterialien sind bekannt. Sie enthalten normalerweise einen Naphthochinondiazidsulfonsäureester eines ein- mehrwertigen Phenols, z. B. eines Polyhydroxybenzophenons, -dinaphthylmethans, -diphenylmethans oder des 4-(2-Phenyl-prop-2-yl)phenols (DE-OS 26 26 473, DE-OS 26 41 099).

Von diesen relativ niedermolekularen Estern werden in der Praxis wegen ihrer relativ hohen Lichtempfindlichkeit, ihrer guten Entwicklerresistenz sowie der hohen Druckauflagen der damit hergestellten Druckplatten besonders die Vertreter mit zwei oder mehreren Naphthochinondiazidgruppen im Molekül bevorzugt. Viele dieser Verbindungen und besonders ihre bevorzugten Vertreter mit relativ hohem Gehalt an Diazogruppen haben aber den Nachteil, daß sie explosionsgefährlich sind. Das bedeutet, daß ihre Herstellung, Lagerung und ihr Transport nur unter ganz besonderen Vorsichtsmaßregeln und in relativ kleinen Portionen erfolgen müssen. Man vermeidet nach Möglichkeit überhaupt die Lagerung und den Transport größerer Mengen derartiger Verbindungen und verarbeitet, wenn möglich, solche Verbindungen am Ort und möglichst bald nach ihrer Herstellung.

Im Zuge des weltweit stark steigenden Verbrauches an positiv arbeitenden, mit o-Chinondiaziden vorsensibilisierten Druckplatten hat es sich jedoch als notwendig erwiesen, Beschichtungsanlagen an einer zunehmenden Zahl von Standorten aufzustellen. Es wäre wünschenswert, derartig verstreute Standorte von einer zentralen Stelle aus gefahrlos mit den erforderlichen Chemikalien versorgen zu können. Dies wird jedoch im Hinblich auf die Naphthochinondiazidsulfonsäureester durch die weltweit gestiegenen Sicherheitsanforderungen erschwert.

Es wurde bereits versucht, das Problem durch Abmischung der explosionsgefährlichen Verbindungen vor dem Transport mit Harzen, z. B. den üblicherweise zugesetzten Phenolharzen, oder mit anderen polymeren Verbindungen zu lösen, doch erfordert auch dies zunächst die Herstellung und Isolierung des gefährlichen Verbindung und ihre Handhabung während des Abmischens. Andere Lösungen des Problems sind unseres Wissens nicht bekanntgeworden, wie überhaupt das Problem selbst bisher kaum druckschriftlich beschrieben ist.

Es ist andererseits bekannt, zur Lösung anderer Aufgaben hochmolekulare o-Chinondiazide herzustellen und zu verwenden.

So wird in der DE-PS 865 860 die Umsetzung von o-Chinondiazidsulfonylhalogeniden mit Phenolharzen und die Verwendung der Reaktionsprodukte zur Beschichtung von Druckplatten beschrieben, wobei die Kristallisation der Chinondiazide in der Schicht vermieden werden soll. Die Lichtempfindlichkeit und andere kopier- und drucktechnische Eigenschaften dieser Verbindungen entsprechen jedoch nicht mehr den heutigen Anforderungen.

In GB-PS 1 113 759 oder DE-OS 28 43 069 werden mit Naphthochinondiazidsulfonsäuren veresterte polymere Kondensationsprodukte von Pyrogallol mit Aceton beschrieben. Diese Produkte sollen eine bessere Haftung gegenüber Aluminium aufweisen. Auch diese Produkte erreichen nicht die Kopier- und Druckleistung der oben genannten niedermolekularen Naphthochinondiazidsulfonsäureester.

In der DE-AS 20 44 868 wird die Verwendung von Estern aus Naphthochinondiazidsulfonsäuren und Polyglykolen zur Herstellung von Photoresistmaterialien beschrieben. Diese Verbindungen sollen eine geringere Sprödigkeit der Schichten bewirken. Sie haben den Nachteil, daß sie wegen ihrer öligen oder harzweichen Konsistenz schwer zu reinigen sind. Sie sind zwar als Photoresistmaterialien geeignet, doch haben sie für die Herstellung von Offsetdruckplatten eine zu geringe Oleophilie und Druckauflage.

In der DE-OS 21 46 166 werden Naphthochinondiazidsulfonsäureester von Bisphenol-Formaldehyd-Kondensationsharzen beschrieben. Auch diese Verbindungen erreichen nicht die kopier- und drucktechnischen Eigenschaften der eingangs genannten niedermolekularen Naphthochinondiazide.

Die DE-OS 30 09 873 beschreibt eine photoempfindliche Masse, die als aktive Komponente ein photoempfindliches Harz enthält, das aus einem cokondensierten Novolakharz, das durch Kondensation von einem Gemisch in einem Molverhältnis von 1 : 9 bis 9 : 1, von mindestens einem $C_3$-$C_{12}$-Alkylphenol und Phenol oder seinen methylsubstituierten Derivaten mit Formaldehyd in einer Menge von 50-100 Molprozent, bezogen auf das Phenolgemisch, hergestellt worden ist und das mit einer o-Naphthochinondiazid-verbindung in einer Menge von 20-100 Molprozent, bezogen auf die Hydroxygruppen in dem Novolakharz, erhalten wurde. Alternativ kann die photoempfindliche Masse auch aus einer o-Benzochinondiazid-verbindung und dem vorstehend beschriebenen cokondensierten Novolakharz bestehen. Der photoempfindlichen Masse kann zusätzlich eine o-Chinondiazidoverbindung zugegeben werden. Als o-Chinondiazidoverbindung werden ein kondensiertes Produkt aus o-Naphthochinondiazidsulfonylchlorid mit einem üblichen alkalilöslichen Phenolnovolakharz, ein kondensiertes Produkt aus o-Naphthochinondiazidsulfonylchlorid mit Phloroglucin, 2,4,6-Trihydroxybenzophenon oder Polyhydroxyphenol ; oder ein kondensiertes Produkt aus o-Benzochinondiazidsulfonylchlorid mit einem an sich bekannten alkalilöslichen Phenolnovolakharz genannt. Die photoempfindliche Masse oder das cokondensierte Novolakharz werden als solche oder als Bindemittel für Druckplattenmaterialien verwendet, die eine hohe Stabilität gegen Fette und Öle besitzen und Beständigkeit gegenüber wäßrigen Alkalilösungen besitzen. Die

Photoempfindlichkeit des Gemischs und die Entwicklungseigenschaften entsprechen jedoch noch nicht den gestellten hohen Anforderungen.

Aufgabe der Erfindung war es, ein lichtempfindliches Gemisch bereitzustellen, dessen Bestandteile in der Handhabung ungefährlich sind und das in seinen Kopier- und Druckeigenschaften mit den besten bisher bekannten Gemischen dieser Art vergleichbar ist.

Gegenstand der Erfindung ist ein lichtempfindliches Gemisch, enthaltend

a) ein wasserunlösliches, in wäßrig-alkalischen Lösungen lösliches Bindemittel und

b) die Ester aus einem Gemisch aus einer niedermolekularen Verbindung definierter Struktur und Molekülgröße, die mindestens zwei phenolische Hydroxygruppen enthält, und einem Phenol-Formaldehyd- oder Kresol-Formaldehyd-Novolak und aus einem Naphthochinondiazidsulfonylhalogenid, in einer Menge, die ausreichend ist, mindestens alle phenolischen Hydroxygruppen des niedermolekularen Anteils zu verestern, mit einem Diazostickstoffgehalt der Ester von 3 bis 8 %.

Erfindungsgemäß wird ferner ein Verfahren zur Herstellung eines Naphthochinondiazidsulfonsäureestergemisches mit einem Diazostickstoffgehalt von 3 bis 8 % vorgeschlagen, bei dem man ein Naphthochinondiazidsulfonylhalogenid mit einem Gemisch aus einer niedermolekularen Verbindung definierter Struktur und Molekülgröße, die mindestens zwei phenolische Hydroxygruppen enthält, und einem Phenol-Formaldehyd- oder Kresol-Formaldehyd-Novolak in einer Menge umsetzt, die ausreichend ist um mindestens alle phenolischen Hydroxygruppen des niedermolekularen Anteils zu verestern.

Die nach dem erfindungsgemäßen Verfahren erhaltenen Veresterungsprodukte können gefahrlos aus dem Reaktionsgemisch isoliert, gereinigt, getrocknet, gelagert und transportiert werden, ohne daß sie irgendwelche Explosionsneigung zeigen. Sie haben andererseits durch ihren Gehalt an niedermolekularen Anteilen im wesentlichen die bekannten vorteilhaften Eigenschaften dieser niedermolekularen Verbindungen.

Als Naphthochinondiazidsulfonylhalogenide werden in bekannter Weise die Chloride bevorzugt. Grundsätzlich sind auch die ebenfalls bekannten Bromide geeignet. Die Verbindungen leiten sich von dem Naphthochinon-(1,2)-diazid, insbesondere dem -diazid-(2) ab. Die Verbindungen können im Molekül eine oder zwei Sulfonylhalogenidgruppen enthalten, die in 3-, 4-, 5-, 6-, 7- oder 8-Stellung des Naphthalinkerns stehen können. Von den Monosulfonsäuren werden zumeist die 4- und 5-Sulfonsäure, die letztere bevorzugt, verwendet. Bei Disulfonsäuren können die Sulfonsäuregruppen z. B. in 3.5-, 3.6-; 4,6- oder 5,7-Stellung stehen.

Als niedermolekulare Phenole kommen bevorzugt Verbindungen mit mindestens zwei Benzolkernen im Molekül in Betracht, die mindestens zwei phenolische Hydroxygruppen enthalten.

Eine bevorzugte Verbindungsgruppe sind Phenole der allgemeinen Formel

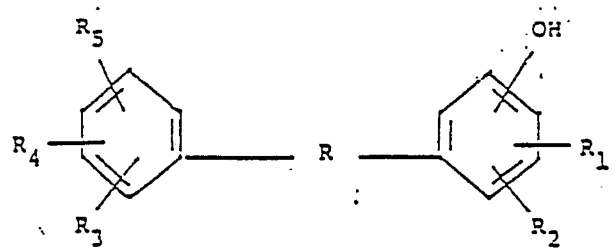

worin

R eine Einfachbindung oder eine der Gruppen CO, S, O, $SO_2$ und $CR_6R_7$, bevorzugt CO oder $CR_6R_7$,

$R_1$, $R_2$, $R_3$, $R_4$ und $R_5$ Wasserstoff- oder Halogenatome, Hydroxygruppen, Alkyl- oder Alkoxygruppen mit 1 bis 4 Kohlenstoffatomen,

$R_6$ und $R_7$ Wasserstoffatome oder Alkylgruppen mit 1 bis 4 Kohlenstoffatomen, bevorzugt Wasserstoffatome oder Methylgruppen, bedeuten oder worin zwei der Reste $R_3$, $R_4$ und $R_5$ und die Reste $R_1$ und $R_2$ jeweils zusammen einen aromatischen Ring bilden, wobei stets mindestens einer der Reste $R_1$, $R_2$, $R_3$, $R_4$ und $R_5$ eine Hydroxygruppe bedeutet.

Beispiele für geeignete niedermolekulare phenolische Verbindungen sind 2,4-Dihydroxy-benzophenon, 2,3,4-Trihydroxy-benzophenon, 2,4,2',4'-Tetrahydroxy-diphenylsulfid. 2,2'-Dihydroxy-dinaphthylmethan, 4,4'-Dihydroxy-2,2'-dimethyl-5,5'-di-tert.-butyl-diphenylsulfid, 4,4'-Dihydroxy-diphenylsulfid, 4,6-Bis-(2,4-dihydroxy-phenylthio)-resorcin, 2,4,2',4'-Tetrahydroxy-3,5,3',5'-tetrabromdiphenyl-sulfon, 2,4,2',4'-Tetrahydroxy-3,5,3',5'-tetrabrom-diphenyl doer 2,4-Dihydroxy-3,5-dibrombenzophenon.

Als Novolake mit phenolischen Hydroxygruppen werden erfindungsgemäß Phenol-Formaldehyd- oder Kresol-Formaldehyd-Novolake verwendet. Die Verwendung der Veresterungsprodukte dieser Harze hat den Vorteil, daß ein Gehalt an unveresterter phenolischer Verbindung nicht stört, da diese ohnehin Bestandteil des Gemisches ist.

Es wird vermutet, daß bei der Veresterung des Gemisches von niedermolekularem Phenol und polymerem Phenol mit dem Sulfonylhalogenid der niedermolekulare Anteil bevorzugt reagiert. Die kopier- und drucktechnischen Eigenschaften des gemischten Veresterungsprodukts werden nämlich

bereits bei realativ geringen Mengenanteilen an niedermolekularem Phenol vorwiegend von diesem niedermolekularen Anteil geprägt und unterscheiden sich deutlich von den Veresterungsprodukten aus reinem Phenolharz und Naphthochinondiazidsulfonsäure, wie sie in der DE-PS 865 890 beschrieben sind.

Das Mengenverhältnis von niedermolekularem zu polymerem Phenol, wie es bei der Veresterungsreaktion eingesetzt wird, sollte im Bereich von 0,1 bis 20, vorzugsweise 0,3 bis 12 Gewichtsteilen polymeres Phenol je 1 Gewichtsteil monomeres Phenol liegen.

Wesentlich für das Ergebnis der Veresterung ist auch das Mengenverhältnis von Naphthochinondiazidsulfonylhalogenid zu phenolischen Verbindungen insgesamt. Die Sulfonylhalogenidmenge sollte vorzugsweise ausreichend sein, um alle phenolischen Hydroxygrupen des niedermolekularen Anteils zu verestern. Ein wichtiges Kriterium für die Brauchbarkeit des veresterten Gemisches ist sein Gehalt an Diazostickstoff. Produkte mit guten Eigenschaften haben Diazostickstoffgehalte von 3 bis 8 %, wobei Produkte mit Werten von 4,5 bis 7,5 besonders bevorzugt werden.

Der Gehalt des gesamten lichtempfindlichen Gemisches, bezogen auf seine nichtflüchtigen Bestandteile, an Naphthochinondiazidsulfonsäureester kann in der gleichen Größenordnung liegen wie bei bekannten Naphthochinondiaziden. Er kann jedoch auch wesentlich höher sein, vor allem dann, wenn das Veresterungsprodukt noch Anteile an unverestertem Phenolharz enthält. Im allgemeinen liegt der Mengenanteil zwischen 5 und 50, vorzugsweise bei 10 bis 30 Gew.-%.

Zur herstellung der gemischten Ester löst man in bekannter Weise das Sulfonsäurehalogenid, bevorzugt ein Sulfonsäurechlorid, in einem geeigneten Lösungsmittel, z. B. Aceton, Butanon, Cyclohexanon, Dichlormethan oder 1,1,1-Trichlorethan. Die phenolischen Verbindungen werden ebenfalls in einem dieser Lösungsmittel gelöst und der Säurechloridlösung zugesetzt. Die Veresterung wird zweckmäßig in Gegenwart von Basen, wie Alkali- oder Erdalkalicarbonaten oder -hydrogencarbonaten, tertiären aliphatischen Aminen oder Pyridin durchgeführt. Das Reaktionsprodukt wird durch Ausfällen mit einem Nichtlöser oder durch Verdampfen der Lösungsmittels, z. B. durch Sprühtrocknung, isoliert und getrocknet.

Das erfindungsgemäße Gemisch enthält außer den beschriebenen lichtempfindlichen Estern weitere übliche Bestandteile von positiv arbeitenden Naphthochinondiazidschichten, insbesondere alkalilösliche Phenolharze.

Die in dem erfindungsgemäßen Gemisch enthaltenen nicht lichtempfindlichen, wasserunlöslichen, alkalilöslichen, filmbildenden Bindemittel haben ein Molekulargewicht von etwa 300 bis 5 000 und werden durch Kondensation von Phenol oder substituierten Phenolen mit Formaldehyd hergestellt. Geeignete substituierte Phenole sind Kresol, Xylenol, Butylphenol und ähnliche. Die besonders bevorzugten alkalilöslichen filmbildenden Phenolharze sind Phenol/Formaldehyd-Novolake, Kresol/Formaldehyd-Novolake und phenolmodifizierte Xylenol/Formaldehyd-Novolake. Die Menge des Bindemittels liegt im Bereich von etwa 50 bis 90 Gew.-%, bevorzugt 65 bis 85 Gew.-% der gesamten nichtflüchtigen Bestandteile.

Die erfindungsgemäßen Gemische können in an sich bekannter Weise noch Füllstoffe, Farbstoffe, Pigmente, photolytische Säurebildner, z. B. 1,2-Naphthochinondiazid-(2)-4-sulfonsäurechlorid, und andere übliche Zusatz- und Hilfsstoffe enthalten.

Als Kopierschichtträger können die in der Reproduktionstechnik üblichen verwendet werden, das sind z. B. Platten oder Folien aus Metall, wie Aluminium oder Zink, mit entsprechend vorbehandelter Oberfläche, Mehrmetallplatten, z. B. aus Chrom/Messing, Chrom/Kupfer/Aluminium, Chrom/-Kupfer/Zink, ferner Papierfolien, Kunststoff-Folien, für den Siebdruck geeignete Gewebe oder metallisierte Isolierstoffplatten. Bevorzugt werden Aluminiumbleche mit entsprechender Vorbehandlung zur Verbesserung der Haftung der Kopierschicht und zur Verbesserung der Hydrophilie der Schichtträgeroberfläche, beispielsweise mechanisch oder elektrochemisch aufgerauhte und gegebenenfalls anodisierte oder chemisch vorbehandelte Al-Bleche.

Die Beschichtung des Trägermaterials erfolgt in an sich bekannter Weise, z. B. durch Antrag mittels Walzen oder Wannen, durch Ausprühen oder Begießen. Ein geeigneter Bereich des Schichtgewichtes auf Trockenbasis liegt zwischen 1,0 und 3,0 g/m².

Die lichtempfindlichen Kopiermaterialien werden nach der Belichtung in üblicher Weise mit wäßrigalkalischen Lösungen, die auch kleinere Mengen organischer Lösungs- oder Netzmittel enthalten können, entwickelt. Die Entwicklung kann durch Tauchen, Bürsten, Sprühen in geeigneten Verarbeitungsgeräten oder manuell durch Überwischen oder Reiben mit einem Tampon erfolgen.

Durch die Erfindung wird eine gefahrlose Handhabung aller Bestandteile des lichtempfindlichen Gemisches erreicht, ohne daß zugleich in bemerkenswerter Weise kopier- und drucktechnische Nachteile, d. h. Verschlechterung der Lichtempfindlichkeit, Entwicklerresistenz der Kopierschicht, der Gradation, des Bildkontrastes oder der Druckauflagenhöhe, in Kauf genommen werden müssen.

Die Erfindung wird im einzelnen anhand der nachfolgenden Beispiele erläutert. Gewichtsteile (Gt) und Volumteile (Vt) stehen im Verhältnis von g/ml. Mengenverhältnisse und Prozentangaben sind, wenn nichts anderes vermerkt ist, in Gewichtseinheiten zu verstehen.

Beispiel 1

Eine elektrolytisch aufgerauhte und anodisch oxidierte Aluminiumplatte, die ein Oxidschichtgewicht

von etwa 3 g/m² hatte, wurde kurze Zeit in eine 0,1 %ige wäßrige Lösung von Polyvinylphosphonsäure on 80 °C getaucht und getrocknet. Auf den so vorbehandelten Schichtträger wurde eine filtrierte Lösung von

1,82 Gt des unten beschriebenen Naphthochinondiazidsulfonsäureesters,
0,215 Gt Naphthochinon-(1,2)-diazid-(2)-4-sulfonylchlorid,
0,07 Gt 2,3,4-Trihydroxy-benzophenon,
6,621 Gt eines Kresol-Formaldehyd-Novolaks mit einem Schmelzbereich von 105-120 °C nach DIN 53181 und
0,079 Gt Kristallviolett in
91,195 Gt eines Gemischs aus 5 Vt Tetrahydrofuran, 4 Vt Ethylenglykolmonomethylether und 1 Vt Butylacetat

aufgebracht und getrocknet. Das so hergestellte lichtempfindliche Material wurde unter einer gerasterten Positivvorlage bildmäßig belichtet und anschließend mit der folgenden Lösung entwickelt :

5,3 Gt Natriummetasilikat x 9 $H_2O$
3,4 Gt Trinatriumphosphat x 12 $H_2O$
0,3 Gt Natriumdihydrogenphosphat (wasserfrei) in
91,0 Gt Wasser

Die erhaltene Druckform lieferte auf einer Offsetdruckmaschine hohe Auflagen.

Die Druck- und Kopiereigenschaften der Platte waren im wesentlichen die gleichen wie die einer entsprechenden Platte, die anstelle des unten beschriebenen Naphthochinondiazidsulfonsäureestergemischs die äquivalente Menge an 2,3,4-Tris-[naphthochinon-(1,2)-diazid-(2)-5-sulfonyloxy]-benzophenon enthielt.

Der in der obigen Rezeptur verwendete Naphthochinondiazidsulfonsäureester wurde wie folgt hergestellt :

Eine Lösung von 25,5 Gt Naphthochinon-(1,2)-diazid-(2)-5-sulfonsäurechlorid in 442 Gt Aceton wurde über Aktivkohle geklärt. In der Lösung wurden 26,3 Gt des oben angegebenen Kresol-Formaldehyd-Novolaks und 4,4 Gt 2,3,4-Trihydroxy-benzophenon gelöst und das Ganze mit einer Lösung von 11,9 Gt $NaHCO_3$ in 124 Gt Wasser und mit 160 Gt gesättigter Natriumchloridlösung versetzt. Das Gemisch wurde 10 Minuten gerührt, absitzen gelassen, die untere Phase verworfen und die Acetonlösung innerhalb weniger Minuten in eine Lösung aus 6 Gt HCl (30 %) und 1 500 Gt Wasser einfließen gelassen. Das ausgeschiedene gelbe flockige Reaktionsprodukt wurde abgesaugt, mit Wasser ausgewaschen und getrocknet. Die Ausbeute betrug 48 Gt. Das Produkt hatte einen Diazostickstoffgehalt von 4,7 % und einen Wassergehalt von 1,8 %.

## Beispiel 2

Beispiel 1 wurde wiederholt, wobei in der Beschichtungsrezeptur der Naphthochinondiazidsulfonsäureester durch die gleiche Menge des wie folgt hergestellten Umsetzungsprodukts ersetzt wurde :

24,7 Gt Naphthochinon-(1,2)-diazid-(2)-5-sulfonylchlorid wurden mit 7,8 Gt des in Beispiel 1 angegebenen Novolaks und 2,1 Gt 2,3,4-Trihydroxy-benzophenon in 455 Gt Aceton in Gegenwart von 20,6 Gt $NaHCO_3$, gelöst in Wasser und Kochsalzlösung, und kleinerer Mengen eines tertiären Amins analog Beispiel 1 umgesetzt. Es wurden 28 Gt eines Produkts mit 7,5 % Diazostickstoff und 1 % Wassergehalt erhalten.

Auch hier waren Qualität und Druckauflage der Druckplatte denen einer entsprechenden Druckplatte mit bekannten niedermolekularen Naphthochinondiazidsulfonsäureestern mindestens vergleichbar.

Ähnliche Ergebnisse wurden erhalten, wenn zur Herstellung des Naphthochinondiazidsulfonsäureesters anstelle des oben angegebenen 5-Sulfonylchlorids die gleiche Menge des isomeren Naphthochinon-(1,2)-diazid-(2)-4-sulfonylchlorids verwendet wurde.

## Beispiel 3

Beispiel 1 wurde wiederholt, wobei in der Beschichtungslösung der Naphthochinondiazidsulfonsäureester durch die gleiche Menge des wie folgt hergestellten Produkts ersetzt wurde :

Analog der in Beispiel 1 angegebenen Herstellungsvorschrift wurden die folgenden Bestandteile umgesetzt :

25 Gt Naphthochinon-(1,2)-diazid-(2)-5-sulfonylchlorid
1 Gt 2,2',4,4'-Tetrahydroxy-diphenylsulfid
2,6 Gt 2,3,4-Trihydroxy-benzophenon
25 Gt des in Beispiel 1 angegebenen Novolaks

Es wurden 47 Gt eines Reaktionsprodukts mit einem Diazostickstoffgehalt von 5,0 % und einem Wassergehalt von 1,8 % erhalten.

Die kopier- und drucktechnischen Eigenschaften der erhaltenen Platte waren mit denen der in Beispiel 1 angegebenen Vergleichsplatte mindestens gleichwertig.

Beispiel 4

Beispiel 1 wurde wiederholt, wobei in der Beschichtungslösung der Naphthochinondiazidsulfonsäuter durch die gleiche Menge des wie folgt hergestellten Produkts ersetzt wurde :

Analog der in Beispiel 1 angegebenen Herstellungsvorschrift wurden die folgenden Reaktionsteilnehmer umgesetzt :

40 Gt des in Beispiel 1 angegebenen Novolaks,
8,35 Gt des Kondensationsprodukts aus 2 Mol 2,3,4-Trihydroxy-benzophenon und 1 Mol Formaldehyd (beschrieben in der DE-OS 28 47 878, Beispiel 1),
48,2 Gt Naphthochinon-(1,2)-diazid-(2)-5-sulfonylchlorid

Es wurden 92 Gt eines Reaktionsprodukts mit einem Diazostickstoffgehalt von 5,0 % und einem Wassergehalt von 0,9 % erhalten.

Die erhaltene Druckplatte war in Qualität und Druckauflage mit bekannten Druckplatten, die ausschließlich niedermolekulare Naphthochinondiazidsulfonsäureester enthielten, vergleichbar.

Ähnliche Ergebnisse wurden erhalten, wenn in der Beschichtungslösung der Naphthochinondiazidsulfonsäureester durch die gleiche Menge des folgenden Reaktionsprodukts ersetzt wurde.

Wie in Beispiel 1 wurden die folgenden Reaktionsteilnehmer umgesetzt :

40 Gt des in Beispiel 1 angegebenen Novolaks,
13,4 Gt des oben angegebenen Kondensationsprodukts aus 2,3,4-Trihydroxy-benzophenon und Formaldehyd,
53,9 Gt Naphthochinon-(1,2)-diazid-(2)-5-sulfonylchlorid

Es wurden 93 Gt eines Reaktionsprodukts mit einem Diazostickstoffgehalt von 5,6 % und einem Wassergehalt von 1,2 % erhalten.

Beispiel 5

Eine elektrolytisch aufgerauhte und anodisch oxydierte Aluminiumplatte, die ein Oxidschichtgewicht von etwa 3 g/m² hatte, wurde mit einer Lösung von

3,83 Gt des unten beschriebenen Naphthochinondiazidsulfonsäureesters,
0,21 Gt Naphthochinon-(1,2)-diazid-(2)-4-sulfonylchlorid,
0,07 Gt 2,3,4-Trihydroxy-benzophenon,
4,31 Gt des in Beispiel 1 angegebenen Novolaks und
0,08 Gt Kristallviolett in
91,50 Gt eines Gemischs aus 5 Vt Tetrahydrofuran, 4 Vt Ethylenglykolmonomethylether und 1 Vt Butylacetat

beschichtet und getrocknet. Das lichtempfindliche Material wurde wie in Beispiel 1 belichtet und entwickelt und ergab eine Flachdruckform, die hohe Auflagen lieferte. Die kopier- und drucktechnischen Eigenschaften der Platte waren im wesentlichen die gleichen wie die der in Beispiel 1 genannten Vergleichsplatte mit einem niedermolekularen Naphthochinondiazidsulfonsäureester.

Der in der obigen Rezeptur verwendete Naphthochinondiazidsulfonsäureester wurde wie folgt hergestellt :

Eine Lösung von 8 Gt Natriumbicarbonat in 84 Gt Wasser und 84 Gt gesättigter Kochsalzlösung wurde innerhalb von 30 Minuten unter Rühren mit einem Schnellrührer mit einer Lösung von 14,7 Gt Naphthochinon-(1,2)-diazid-(2)-5,7-bis-sulfonylchlorid, 18,4 Gt des in Beispiel 1 angegebenen Novolaks und 4,6 Gt 2,3,4-Trihydroxy-benzophenon in 363 Gt Tetrahydrofuran versetzt. Nach Absitzen und Abtrennen der unteren Flüssigkeitsphase wurde die Lösung mit 174 Gt Tetrahydrofuran verdünnt und das Reaktionsprodukt durch Eingießen in eine Lösung von 6 Gt 30 %iger Salzsäure in 600 Gt Wasser innerhalb von 10 Minuten ausgefällt. Nach Absaugen, Neutralwaschen mit Wasser und Trocknen wurden 34,1 Gt eines gelben Produkts mit 3,1 % Stickstoffgehalt und 0,7 % Wassergehalt erhalten.

Wenn anstelle des oben beschriebenen Naphthochinondiazidsulfonsäureesters die gleiche Menge des Umsetzungsprodukts aus 37 Gt Naphthochinon-(1,2)-diazid-(2)-5-sulfonylchlorid, 18,6 Gt eines Polykondensationsprodukts aus Pyrogallol und Aceton und 2,3 Gt 2,3,4-Trihydroxy-benzophenon verwendet wurde, wurden ähnliche Ergebnisse erhalten.

Beispiel 6

Zur Herstellung einer Photoresistlösung wurden

7 Gt des in Beispiel 1 beschriebenen Naphthochinondiazidsulfonsäureesters und

23 Gt eines Kresol-Formaldehyd-Novolaks mit dem Erweichungsbereich von 105-120 °C, gemessen nach Kapillarmethode DIN 53181, in

83 Gt eines Lösungsmittelgemischs aus

82 % Ethylenglykolethyletheracetat,

9 % Butylacetat und

9 % Xylol

gelöst, und die viskose Lösung wurde filtriert. Die erhaltene Lösung wurde auf handelsübliches mit einer 30 µm dicken Kupferfolie kaschiertes Isolierstoffmaterial so aufgeschleudert, daß nach dem Trocknen eine Schichtdicke von ca. 1 µm erhalten wurde. Die Schicht wurde unter eine Schaltungsvorlage belichtet und mit dem in Beispiel 1 angegebenen Entwickler entwickelt, wobei die belichteten Schichtteile ausgewaschen wurden. Das freigelegte Kupfer wurde mit Eisen-III-chloridlösung weggelöst, und die Resistschablone wurde durch Belichten mit einer Metallhalogenidlampe und Überwischen mit der Entwicklerlösung entfernt. Es wurde eine kopierte Schaltung erhalten.

**Patentansprüche**

1. Lichtempfindliches Gemisch, enthaltend

a) ein wasserunlösliches, in wäßrig-alkalischen Lösungen lösliches Bindemittel und

b) die Ester aus einem Gemisch aus einer niedermolekularen Verbindung definierter Struktur und Molekülgröße, die mindestens zwei phenolische Hydroxygruppen enthält, und einem Phenol-Formaldehyd- oder Kresol-Formaldehyd-Novolak und aus einem Naphthochinondiazidsulfonylhalogenid, in einer Menge, die ausreichend ist, mindestens alle phenolischen Hydroxygruppen des niedermolekularen Anteils zu verestern, mit einem Diazostickstoffgehalt der Ester von 3 bis 8 %.

2. Lichtempfindliches Gemisch nach Anspruch 1, dadurch gekennzeichnet, daß die Ester Umsetzungsprodukte eines Naphthochinon-(1,2)-diazid-(2)-sulfonsäurechlorids sind.

3. Lichtempfindliches Gemisch nach Anspruch 1, dadurch gekennzeichnet, daß die niedermolekulare phenolische Verbindung der Formel

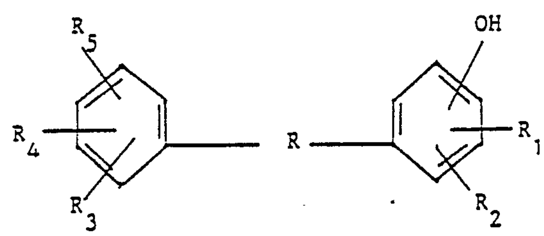

entspricht, worin

R eine Einfachbindung oder eine der Gruppen CO, S, O, $SO_2$ und $CR_6R_7$,

$R_1$, $R_2$, $R_3$, $R_4$ und $R_5$ Wasserstoff- oder Halogenatome, Hydroxygruppen, Alkyl- oder Alkoxygruppen mit 1 bis 4 Kohlenstoffatomen.

$R_6$ und $R_7$ Wasserstoffatome oder Alkylgruppen mit 1 bis 4 Kohlenstoffatomen bedeuten

oder worin zwei der Reste $R_3$, $R_4$ und $R_5$ und die Reste $R_1$ und $R_2$ jeweils zusammen einen anellierten aromatischen Ring bilden.

wobei stets mindestens einer der Reste $R_1$, $R_2$, $R_3$, $R_4$ und $R_5$ eine Hydroxygruppe bedeutet.

4. Lichtempfindliches Gemisch nach Anspruch 1, dadurch gekennzeichnet, daß das Bindemittel ein Phenolharz ist.

5. Lichtempfindliches Gemisch nach Anspruch 1, dadurch gekennzeichnet, daß es 5 bis 50 Gew.-%, bezogen auf das Gewicht der nichtflüchtigen Bestandteile, Naphthochinondiazidsulfonsäureester enthält.

6. Verfahren zur Herstellung eines Naphthochinondiazidsulfonsäureestergemisches mit einem Diazostickstoffgehalt von 3 bis 8 %, bei dem man ein Naphthochinondiazidsulfonylhalogenid mit einem Gemisch aus einer niedermolekularen Verbindung definierter Struktur und Molekülgröße, die mindestens zwei phenolische Hydroxygruppen enthält, und einem Phenol-Formaldehyd- oder Kresol-Formaldehyd-Novolak in einer Menge umsetzt, die ausreichend ist um mindestens alle phenolischen Hydroxygruppen des niedermolekularen Anteils zu verestern.

7. Verfahren nach Anspruch 6, dadurch gekennzeichnet, daß man die niedermolekulare Verbindung und die polymere Verbindung in einem Gewichtsverhältnis von 1 : 0,1 bis 1 : 20 einsetzt.

## Claims

1. A light-sensitive mixture containing

a) a binder which is insoluble in water and soluble in aqueous-alkaline solutions and

b) the esters formed from a mixture composed of a low-molecular compound of defined structure and molecular size, containing at least two phenolic hydroxyl groups and a phenol-formaldehyde or cresol-formaldehyde novolak and from a naphthoquinonediazidesulfonyl halide, in a quantity which is sufficient to esterify at least all phenolic hydroxyl groups of the low-molecular constituent, with a diazo-nitrogen content of the esters of 3 to 8 %.

2. A light-sensitive mixture as claimed in claim 1, wherein the esters are reaction products of a 1,2-naphthoquinone-2-diazide-sulfonic acid chloride.

3. A light-sensitive mixture as claimed in claim 1, wherein the low-molecular phenolic compound corresponds to the formula

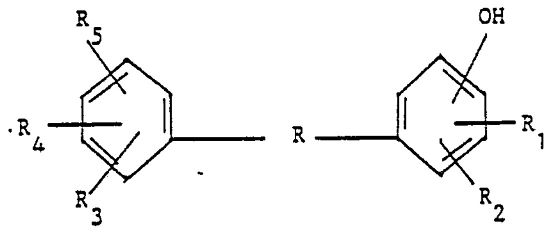

in which

R denotes a single bond or one of the groups CO, S, O, $SO_2$ and $CR_6R_7$ ;

$R_1$, $R_2$, $R_3$, $R_4$ and $R_5$ denote hydrogen or halogen atoms, hydroxyl groups or alkyl or alkoxy groups having 1 to 4 carbon atoms ;

$R_6$ and $R_7$ denote hydrogen atoms or alkyl groups having 1 to 4 carbon atoms ;

or in which two of the radicals $R_3$, $R_4$ and $R_5$ and the radicals $R_1$ and $R_2$, in each case jointly form a fused aromatic ring,

at least one of the radicals $R_1$, $R_2$, $R_3$, $R_4$ and $R_5$ denoting a hydroxyl group in all cases.

4. A light-sensitive mixture as claimed in claim 1, wherein the binder is a phenolic resin.

5. A light-sensitive mixture as claimed in claim 1, which contains 5 to 50 % by weight, relative to the weight of the non-volatile constituents, of a naphthoquinonediazidesulfonic acid ester.

6. A process for the preparation of a naphthoquinonediazidesulfonic acid ester mixture having a diazo-nitrogen content of 3 to 8 %, in which a naphthoquinonediazide-sulfonyl halide is reacted with a mixture composed of a low-molecular compound of defined structure and molecular size, containing at least two phenolic hydroxyl groups and a phenol-formaldehyde or cresolformaldehyde novolak, in a quantity which is sufficient to esterify ast least all phenolic hydroxyl groups of the low-molecular constituent.

7. A process as claimed in claim 6, wherein the low-molecular compound and the polymeric compound are employed in a ratio by weight of 1 : 0.1 to 1 : 20.

## Revendications

1. Mélange photosensible contenant

a) un liant insoluble dans l'eau, mais soluble dans des solutions aqueuses-alcalines et

b) les esters obtenus à partir d'un mélange d'un composé de faible masse moléculaire, de structure et de grandeur moléculaire définies, qui contient au moins deux groupes hydroxy phénoliques, et une novolaque de phénol-formaldéhyde ou crésol-formaldéhyde, et d'un halogénure de naphtoquinonediazidesulfonyle, en une quantité qui est suffisante pour estérifier au moins tous les groupes hydroxy phénoliques de la fraction de faible masse moléculaire, avec une teneur en azote diazo des esters de 3 à 8 %.

2. Mélange photosensible selon la revendication 1, caractérisé en ce que les esters sont des produits de réaction d'un chlorure d'acide 1,2-naphtoquinone-2-diazide-sulfonique.

3. Mélange photosensible selon la revendication 1, caractérisé en ce que le composé phénolique, de faible masse moléculaire, répond à la formule

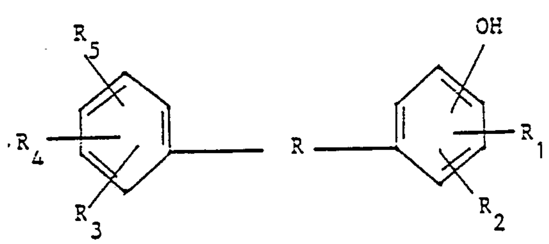

dans laquelle

R représente une simple liaison ou un des groupes CO, S, O, $SO_2$ et $CR_6R_7$,

$R_1$, $R_2$, $R_3$, $R_4$ et $R_5$ représentent des atomes d'hydrogène ou d'halogènes, des groupes hydroxy, des groupes alkyle ou alkoxy ayant de 1 à 4 atomes de carbone,

$R_6$ et $R_7$ représentent des atomes d'hydrogène ou des groupes alkyle ayant de 1 à 4 atomes de carbone,

ou dans laquelle, deux des radicaux $R_3$, $R_4$ et $R_5$ et les radicaux $R_1$ et $R_2$ forment chacun ensemble un noyau aromatique condensé,

où au moins toujours un des radicaux $R_1$, $R_2$, $R_3$, $R_4$ et $R_5$ représente un groupe hydroxy.

4. Mélange photosensible selon la revendication 1, caractérisé en ce que le liant est une résine phénolique.

5. Mélange photosensible selon la revendication 1, caractérisé en ce qu'il contient de 5 à 50 % en poids, par rapport au poids des constituants non-volatils, d'ester d'acide naphtoquinonediazide sulfonique.

6. Procédé pour la préparation d'un mélange d'esters d'acide naphtoquinonediazide sulfonique ayant une teneur en azote diazo de 3 à 8 %, dans lequel on fait réagir un halogénure de naphtoquinonediazide sulfonyle avec un mélange d'un composé de faible masse moléculaire, ayant une structure et une grandeur moléculaire définies, qui contient au moins deux groupes hydroxy phénoliques, et d'une novolaque de phénol-formaldéhyde ou crésol-formaldéhyde en une quantité qui est suffisante pour estérifier au moins tous les groupes hydroxy phénoliques de la fraction de faible masse moléculaire.

7. Procédé selon la revendication 6, caractérisé en ce qu'on utilise le composé de faible masse moléculaire et le composé phénolique dans un rapport pondéral de 1 : 0,1 à 1 : 20.